Europäisches Patentamt

European Patent Office

Office européen des brevets

(11) Publication number: **0 165 575 B1**

# EUROPEAN PATENT SPECIFICATION

(45) Date of publication of patent specification: **25.09.91**   (51) Int. Cl.⁵: **H01L 23/52**, H01L 21/48

(21) Application number: **85107402.1**

(22) Date of filing: **15.06.85**

(54) Method for forming vias in a planar structure.

(30) Priority: **22.06.84 US 623584**

(43) Date of publication of application:
**27.12.85 Bulletin 85/52**

(45) Publication of the grant of the patent:
**25.09.91 Bulletin 91/39**

(84) Designated Contracting States:
**DE FR GB**

(56) References cited:
**EP-A- 0 099 544**
**FR-A- 2 150 923**
**US-A- 3 410 979**

**IBM TECHNICAL DISCLOSURE BULLETIN, vol. 14, no. 1, June 1971, page 101, New York, US; A.P. DAVID et al.: "Producing integral via and pad metallurgy"**

(73) Proprietor: **International Business Machines Corporation**
**Old Orchard Road**
**Armonk, N.Y. 10504(US)**

(72) Inventor: **Leary-Renick, Pamela Anne**
**12 Hemlock Court**
**Fishkill New York 12524(US)**
Inventor: **Strinivasan, Rangaswamy**
**2508 Dunning Drive**
**Yorktown Heights New York 10598(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The invention relates to a method for forming vias in a planar structure that serves as a support for integral mounting thereon of semiconductor chips or devices having the features given in claim 1.

As the integrated circuit technology advances towards large-scale integration and high performance circuits, it is necessary to provide interconnection electrical packaging which is compatible with the performance demands of associated circuitry. Thus, the problem of signal delay, package impedance, and cross-talk are extremely critical. Known prior art packaging materials often do not possess appropriate controllable dielectric properties to accommodate high performance circuits in large-scale integration schemes.

In U.S. Patents No. 3,726,002, No. 3,968,193 and No. 4,221,047, it has been proposed to form a high-quality and high-performance multi-layered substrate support for interconnection to semiconductor or integrated circuit devices, of fabricating a complex thin film interconnection package superstructure on a dissimilar ceramic (e.g. alumina, glass-ceramic, etc.) substrate by forming a plurality of glass layers over the substrate, with deposition of a plurality of thin film metallization patterns on each layer of deposited glass, selectively depositing vertical conductive studs or extensions for electrical interconnection between various conductive patterns, followed by bonding a plurality of integrated circuit chips to the surface of the glass package superstructure.

Although various compatible glass compositions can be employed for the package superstructure, borosilicate glasses have found preference due, among other properties, to its low fusion temperature, excellent dielectric properties, adhesion compatibility to alumina ceramics, and resistance to subsequent processing of the package (e.g. reworking, such as bonding and/or replacement of chips or devices).

However, when borosilicate glasses have been employed, difficulty has been encountered in the use of standard photoresist masking technology to produce or form vias or feedthrough holes in the multi-component layers of these glasses, when of substantial thicknesses. Investigation of the causes therefor indicate that the reason for this was that commonly used organic photoresists for semiconductor fabrication are not chemically durable enough to withstand the attack of etchants which are typically used and required for complete dissolution of borosilicate glass layers of substantial thicknesses, e.g., on the order of 10 micrometers. Although the patterned photoresist is normally not soluble in the glass-etchants, it floats away from the borosilicate glass dielectric surface (due to the lateral attack of the etchant along the resist/glass interface) in short periods of time (e.g., on the order of 45 seconds) when exposed to the etchant, allowing the borosilicate glass dielectric layer to be attacked in undesired areas, thereby exposing the layer to pin-holing problems and problems with undesired variations in borosilicate glass thickness, both of which could lead to electrical problems (e.g. shorts) in the final film redistribution-metal fan-out lines on the glass surfaces.

Also, as the resist is loosened and removed, as discussed above, the side walls of the via or reach-through holes becomes very shallow due to the excess undercutting of the resist, with the obtention of an acceptable via taper becoming substantially uncontrollable.

Also other dielectric materials can be used, as for example, the thin film glass-ceramics described in the aforesaid U.S. Patent No. 4,221,047. The glass-ceramics have a two-phase structure comprised of discrete particles of glass dispersed through a crystalline (e.g., predominately cordierite, $2\ MgO - Al_2O_3 - SiO_2$) phase, which makes etching extremely difficult. Conventional etching processes, such as wet etching with buffered hydrofluoric acid, or reactive ion etching, have been found to be unacceptable due to anisotropic etching of the different constituents in the glass-ceramic. In addition, these two conventional processes are extremely slow, and require photolithographic etch masks.

The invention as claimed is intended to remedy these drawbacks. It solves the problem of providing a method for forming vias in a planar structure, which substantially minimizes if not eliminates the drawbacks discussed before. The advantages of the invention are achieved by adaptation to this purpose of the ablative photodecomposition (APD) technique of D. L. Klein et al. as described in their IBM Technical Disclosure Bulletin (TDB) article "Ablative Photodecomposition Process for Repair of Line Opens", pp. 4669-4671, Vol. 26, No. 9, February 1984. In the Klein et al article the APD technique is described in its application to the selective removal of portions of resist layers. In this TDB, the resist decomposition is effected by the incidence of ultraviolet radiation of wavelengths less than 220 nm (nanometers), and power densities sufficient to cause fragmentation of resist polymer chains and the immediate escape of the fragmented portions from the resist layers. This ablation can be effected from conventional high powered pulsed sources.

For further discussions of the removal of organic films, including resists, reference is made to U.S. Patent 4,414,059 and U.S. Patent 4,417,948.

As background of the foregoing, attention is also directed to U.S. Patent No. 3,410,979 "Method and Apparatus for Drilling Holes by Means of a Focused Laser Beam" and U.S. Patent No. 3,323,198 "Electrical Interconnections".

Accordingly, it is an object of this invention to eliminate disadvantages of the prior art.

It is another object of this invention to provide a dry-etching technique for the formation of via patterns in dielectric objects or substrates without use of photoresists.

It is a further object of this invention to ablatively etch patterned recesses in dielectric materials without need of photoresists.

In the invention herein, the use of a resist is not required nor employed, and the via pattern is formed directly with the use of a metal mask, having a pattern of openings, to screen the high energy pulsed radiation in a corresponding pattern on the borosilicate glass. Although, high powered ultraviolet pulsed radiation represents a preferred form of the invention, it is to be understood that lasers and dry etching can also be employed to form the via holes.

The laser radiation incident on the surface of the dielectric (borosilicate glass) film produces etching through an undetermined mechanism. By using an appropriate mask, e.g., (a metal such as molybdenum) to selectively block the laser radiation, any suitable pattern can be etched through the dielectric film. The areas exposed to the beam can also be adjusted over a wide range. For example, by imaging through a metal mask, larger features, greater than 50 $\mu$m (e.g., about 100 $\mu$m) can be readily etched. Smaller features, (e.g., 50 $\mu$m or less) can be defined by reducing the image formed by passing the laser through a mask. This could be done with a lense system.

It is surmised that in APD, a large number of photons of a particular wavelength are directed to the material in a short time. The efficiency of absorption of these photons is very high to result in the decomposition of the material which produces fragmentation products in a small volume in a short amount of time. This causes a localized increase in volume which cannot be sustained, and the pressure is relieved by the process of ablation, wherein the fragments, in effect, explode and escape from the material, leaving an etched material. In this process, a rapid and large amount of fragmentation is initiated at the surface of the material in order to allow successive fragmented by-products to explode and escape as the ablative-etching proceeds into the material. The process is such that portions of the incident energy is transferred as kinetic energy of the ablated by-products.

Also, it is to be understood, that the process is not to be considered as limited to the ablative etching of single dielectric (e.g., borosilicate, glass-ceramic, etc.) films in that they are explicitly comprehended for the formation of the superstructure films described in the patents noted above (for example, U.S. 4,221,047). After ablative-etching of a first dielectric film, new layers can be deposited and fired on top of existing films, at any time, resulting, after fusion, in a continuous homogeneous structure. By ablative pattern-etching the dielectric film, with the laser, and then depositing conductive metallurgy into the vias or grooves generated, a planar structure can be obtained. The process can then be repeated any number of times required.

The invention is described in detail below with reference to the drawings of which:

Fig. 1    illustrates a semiconductor integrated circuit package for interconnecting a plurality of semiconductor chips on a single substrate, and a perspective view is partially broken away to illustrate the manner in which the dielectric film/metal portion is constructed.

Fig. 2    is a partial cross-sectional view taken along lines 2-2, and more specifically illustrates the multi-levels of interconnection for the package.

Fig. 3    is an enlarged plane view of a single chip site shown generally in Fig. 1, and illustrates the manner of interconnecting a particular chip to its upper surface metallurgy.

Figs. 4A-4H    are schematic step by step cross-sectional views illustrating a preferred embodiment for fabricating the dielectric film/metal portion of the overall superstructure portion of the interconnection package.

Fig. 5    is a schematic illustration of an apparatus indicated as an alternative means for employment in this invention.

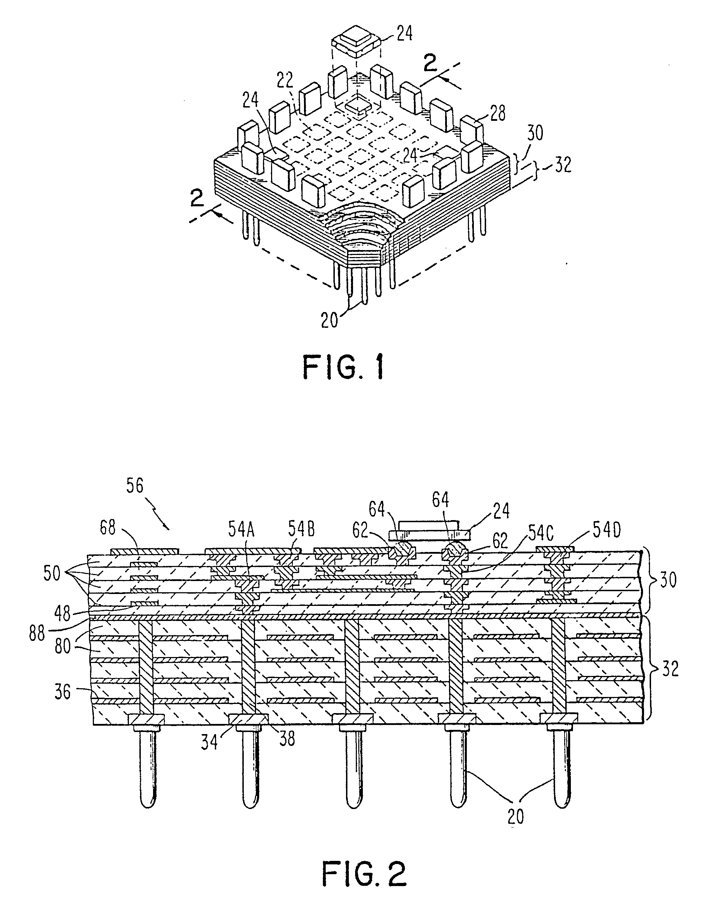

Referring to Figs. 1, 2, and 3, illustrated therein are structural details of an interconnection structure necessary for communicating from the outside world via a plurality of pins 20 to a plurality of chip sites 22. A plurality of chips 24 populate each chip site 22. Components, such as, capacitors 28, are readily mounted at the periphery of the package. The interconnection metallurgy, shown more specifically in Fig. 2, also establishes voltage distribution planes, ground planes, X-Y signal planes, and voltage redistribution planes.

In this embodiment, a dielectric film/metal superstructure as package 30 is joined to a multi-layer ceramic base 32. A plurality of pads 34 located on the under surface of the multi-layer base 32, each connects to the pins 20. In this embodiment, the pads 34 can comprise a nickel plated tungsten metal, which have been joined to the pins 20 by brazing. It will be understood that although the base structure 32 is indicated as a ceramic base, it could be comprised of alumina ceramic or glass-ceramics, and the like.

The multi-layer ceramic base 32 includes a multi-level metallization generally indicated at 36 at a plurality of planes. Further, vertical conductive paths through the multi-layer ceramic base 32 are provided by a plurality of metal-filled vias 38. The base 32 electrically functions to provide input-output connection to the pins 20 and to provide voltage distribution planes. The number of voltage distribution planes are governed by the voltage requirements of the circuit logic family existing at the chip level.

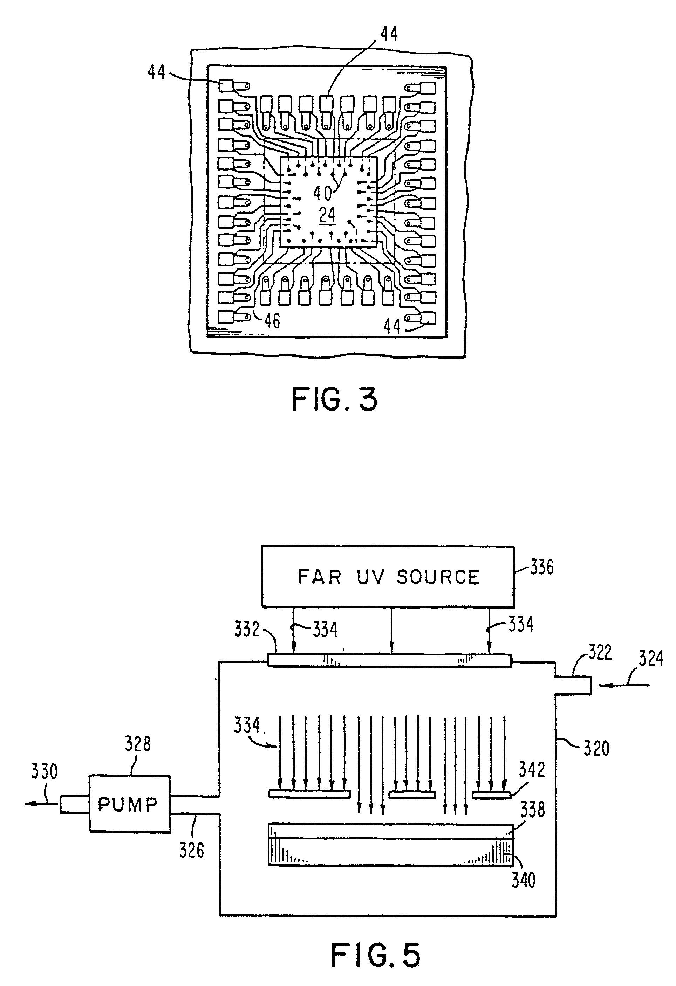

Also, the base 32 contains redistribution planes. Redistribution planes provide an interconnection translation which is necessary because of pins 20 communicating with the external world constitute a larger size grid than the grid existing at the semiconductor chip level, as represented by a plurality of paths schematically shown at 40 in Fig. 3. Also, Fig. 3 illustrates the ease with which interconnections are made from a plurality of pads 44, located on the upper surface of the dielectric film/metal module superstructure 30, to the plurality of conductive lines 46. Lines 46 are formed by metal deposition steps, but upper surface connections can be further implemented by wire bonding, thermal compression bonding, etc.

The dielectric film/metal superstructure 30 comprises metallurgy planes generally shown at 48 located at multi-levels or planes separated by a plurality of insulating dielectric layers 50. Vertical interconnections between the different levels and the multi-layer ceramic substrate 32 are provided by a plurality of conductive studs 54.

Although, as indicated above, various dielectric films (such as glass-ceramic films) can be employed in this invention, this embodiment will be described with specific reference to the use of borosilicate glass films in general, and more particularly with respect to multi-component borosilicate glass dielectric films, as used in the fabrication of semiconductor devices of any type.

While not to be construed as limited, typical borosilicate glasses which can be etched in accordance with the present invention comprise primarily $SiO_2$ and $B_2O_3$, typically on the order of about 65 to 80 wt. parts silicon dioxide, about 20 to about 35 wt. parts $B_2O_3$, with up to about 20 wt. parts conventional materials as are used in such glass compositions, e.g., one or more of $Al_2O_3$, $Na_2O$, $K_2O$, CaO, etc. A typical multi-component borosilicate glass composition which can be employed in the present invention has the following composition, with all parts by weight percent:

| | | | |
|---|---|---|---|
| $SiO_2$ | 65.0 | $Na_2O$ | 3.0 |
| $B_2O_3$ | 20.0 | $K_2O$ | 5.0 |
| $Al_2O_3$ | 7.0 | CaO | 1.0 |

These borosilicate glasses can have various ranges of their component, but the specific composition will be referred to as Composition A.

These borosilicate glasses can have varying thicknesses, but typically, the borosilicate glasses for purposes of this application can have film thicknesses on the order of about 10 $\mu$m and up to about 25 $\mu$m.

Borosilicate glass layers employed in this invention can be formed in a conventional manner as will be appreciated by one skilled in the glass art. For example, one merely mixes the various desired oxides in the desired proportion and melts them at about $1000°$ C to form the desired borosilicate glass, these fused glasses are then fritted to suitable particle size to form a layer thereof by, mixing in a suitable carrier, which slurry is deposited as a layer on the surface and a glass layer formed therefrom by conventional firing procedure.

In Fig. 2, the top level metallurgy is generally designated by 56 schematically corresponding to the paths and conductive lines shown in Fig. 3, as elements 44 and 46, respectively. The semiconductor chips 24 are joined to predetermine conductive paths by a metallurgical system and solder connection illustrated at 62 and 64, respectively.

In order to allow for engineering changes, the top level metallurgy 56 is provided with engineering change pads 68. Basically, the engineering change pads 68 are comprised of a material which is softer than the metallurgy 56 itself. Accordingly, severing pressure applied on the upper surface of the metallurgy 56 in the area of the pads 68 breaks the metal line. Re-routes or engineering changes are then available by making other connections, for example, wire bonding. Only one engineering change pad 68 is illustrated; however, in actual practice, numerous pads would be located throughout the upper layer metallurgy. Pad 68 may be formed of the material such as a polyimide polymer which would cushion any severing forces, thus preventing damage to the upper dielectric film surface, but their existence is not absolutely required in all instances. Other details of this type of packaging can be obtained by reference to the patents referred to above.

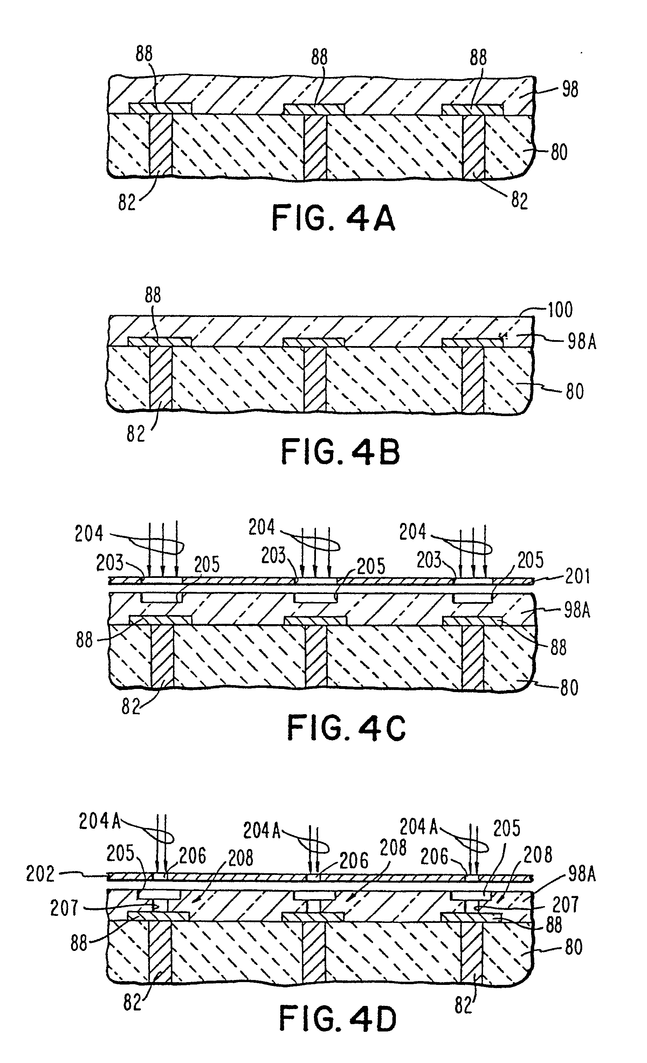

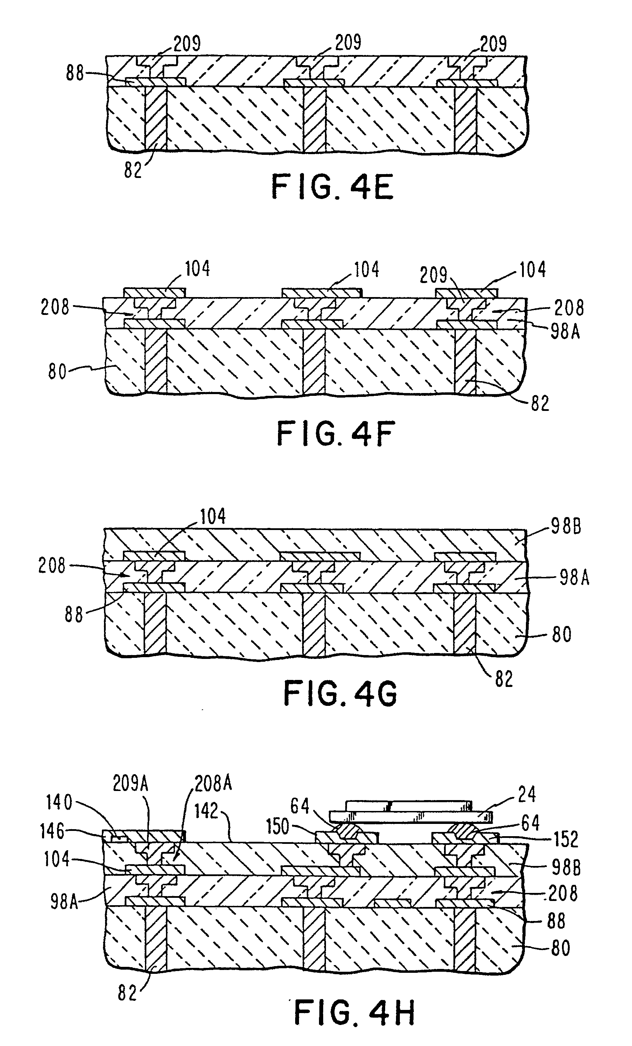

Figs. 4A-4H illustrate the process for fabricating the dielectric film/metal superstructure shown generally at 30 in Figs. 1 and 2.

Referring to Fig. 1 the pre-formed ceramic body 80 having conductive vias 82 is lapped flat to a predetermined thickness. In this embodiment, the overall thickness of the multi-level ceramic superstructure 30, Figs. 1 and 2, is approximately 125 $\mu$m thick, ± 75 $\mu$m. It is necessary to lap the upper surface to flatness or planarity within 2.5 to 5 $\mu$m. Lapping can be accomplished with a free or resin bonded abrasive pad followed by suitable cleaning of the ceramic body, for example, as described in the aforesaid indicated U.S. Patent No. 3,968,193.

For purpose of illustration, in this embodiment, the ceramic base substrate 32 is comprehended to be comprised essentially of an alumina or $Al_2O_3$ composition. However, other compositions such as mullite, berylium oxide, magnesium, or other materials, (for example, the glass ceramic of the aforesaid U.S. Patent No. 4,221,047) which have a suitable thermal conductivity and dielectric properties can be employed.

After conditioning of the upper surface of the ceramic body 80, a blanket metallization layer 36 of suitable conductive composition is deposited thereon. The deposition can be accomplished by employing three separate sequential metal evaporations comprising chromium-copper-chromium. Illustratively, for this embodiment, the metallization layer 36 can comprise a lower chrome layer of approximately 80 nm thickness and an overlying copper layer approximately 3 $\mu$m thick, and a top chrome layer approximately 80 nm thick. After deposition of the conductive sandwich, it can be subjected to selective etching operations. Suitable etching techniques can be selected to provide a personalized metallization pattern comprised of a plurality of lines 88 comprising a chrome-copper-chrome metallurgical system. Alternatively, the metal line resolution can be obtained by use of lift-off resist, E-beam blanket evaporated metal. A typcial line pattern is of a 12 micrometers width on a 12 micrometer spacing between metal lines.

After delineation of the conductive metallurgical pattern 88, a borosilicate glass slurry (e.g., composition A) is deposited on the ceramic surface 80 to form, after firing, a fused layer 98 to a thickness extending well above the conductive pattern 88. The slurry can be deposited, for example, (as in the prior art noted above) by doctor blading or spraying. The slurry is formed of glass frit in a suspending medium, such as terpineol. In order to realize the desired physical and dielectric characteristics of the insulating glass layer, it is important to form the glass slurry into a homogeneous and uniform dispersion.

The deposited glass slurry layer is dried to drive off the suspending medium and then fired to fuse the glass particles together.

After the layer 98 is cooled, it is necessary to condition the upper surface prior to subsequent steps. As illustrated in Fig. 4B, the glass layer 98 is lapped to provide an upper planar surface 100. The lapping operation serves several functions. Firstly, it provides for (1) planar surface and (2) a surface finish necessary for subsequent operations. Whether it allows exact (3) thickness control of layer 98. Thereafter, the upper surface 100 may be refired to remove any flaws caused by the lapping operation.

In the next operation, a metal mask 201 (e.g., of molybdenum) is superposed over the lapped glass layer 98A. The mask 201 will be provided with a pattern of openings 203 in accordance with a desired pattern of vias at predetermined portions on the glass layer 98A. After superpositioning of mask 201, the surface portions of the glass layer 98A exposed by the mask openings 203 are irradiated with wavelengths of ultraviolet radiation 204 having a wavelength less than about 220 nm, (e.g., 193 nm) to ablatively decompose portions of the glass layer 98A through only a portion of glass layer 98A wherein the bottom of the recess 205 is spaced from the bottom glass layer 98A. As will be understood, those portions to be irradiated are determined by the openings 203 in mask 201. As indicated above for purpose of this embodiment, the borosilicate glass will have the Composition A described above, with the mask openings 203 being about 100 $\mu$m. In this embodiment, the lapped glass layer 98A will have a thickness of about 48 $\mu$m, with the recess 205 formed at 12 Hz for 4 minutes which etch through 33 micro-meters of the fused glass Composition A layer 98A.

Subsequent to the formation of the recessed pattern 205, the mask 201 is substituted with a second mask 202 having smaller 50 $\mu$m openings 206. In mask 202, the openings 206 will have a pattern of openings corresponding to the 203 opening pattern of mask 301, however with the openings 206 being located concentrically with the recesses 205, so that on irradiation with ultraviolet irradiation 204A having a wavelength less than 220 nanometer (e.g., of about 193 nm), a smaller recess is formed in extension to the metal pattern segments 88 as shown in Fig. 4D, the resultant via 207 has a step-shoulder or counter bored configuration 208.

Following the formation of the pattern of step-shoulder vias 207, a suitable conductive metal can be deposited in these vias to form the vertical interconnections or studs 209.

Shown in Fig. 4F is an illustration of a selective personalization of the second level metallurgy formed in a manner identical to that previously described above. The result of this operation leaves a selective metallization pattern indicated at 104. Thereafter, the identical steps, as described above are repeated to overcoat the second level metallization 104 with a second fused borosilicate Composition A glass film which is lapped to form the second level borosilicate glass layer 98B, as shown in Fig. 4G.

Here again, the two mask procedure is employed to ablatively form the stepped-shoulder vias 208A into which are deposited conductive studs 209A.

A metal vacuum deposition step, with suitable personalization, is formed on the upper surface of metal layer 98B to form engineering change pads 140 which can also serve as a cushion for subsequent engineering changes once the entire package is chip populated. Thereafter, suitable metallization is again deposited and delineated on the top of the borosilicate glass layer 98B to form a selective metallized pattern, a portion of which is illustrated at 146. The resultant structure is illustrated in Fig. 4H, with it being understood that the metallurgy pattern 146 may comprise any suitable conductive system, and may for this specific embodiment, be comprised of a chrome-copper-chrome combination of metals.

Fig. 4H also illustrates the deposition step for providing a pair of chip lands 150 and 152. In this embodiment, the chip lands 150 and 152 each comprise a chromium-copper-gold metallurgical system. Although not shown, the well known solder re-flow techniques can then be employed to join the chip pads to the respective chips as illustrated at 150 and 152. Via the solder bounds 64 which form the bond to chip 24. Chip bonding using the solder re-flow process is illustrated in U.S. Patents No. 3,374,110; No. 3,429,949; and No. 3,495,133.

Although the irradiation of the dielectric or borosilicate glass layer 98A and 98B can be effected by controlled deflection of the irradiation, is to be understood that the irradiation may be effected by blanket irradiation of the glass layer 98A and 98B in suitable apparatus.

Fig. 5 shows an apparatus which is suitable to carry out the ablative photodecomposition set forth in this application. This apparatus may be comprised of a vacuum chamber 320 having an input port 322 to which gases, including air, can be admitted as indicated by the arrow 324. Chamber 320 is provided with an output port 326 to which a pump 328 is attached for removing volatile gas by-products and gasses from chamber 320 as indicated by arrow 330. A quartz window 332 allows ultraviolet irradiation 334 to enter chamber 320. This irradiation is provided by the far-UV source 336, which produces irradiation of wavelengths of about 193 or 248 or 308 nm, and a sufficient power density to produce ablative photodecomposition.

Located within chamber 320 is the substrate 340 having the superstructure 338 which is to be patterned. Substrate 340 can be comprised of a multitude of layers as discussed above, including metals, insulators, and semiconductors. The superstructure layer 338 is present for purposes of patterning by ablative photodecomposition. Also shown is a mask 342 which is used to define the areas of the superstructure 338 which is to be irradiated. As noted, the UV source 336 is typically a laser source which will provide a sufficient number of photons of at least a threshold energy fluence in a very short amount of time, the amount of energy and the period of time being chosen to be sufficient to ablatively photodecompose the irradiated areas of layer 338. The wavelength of the ultraviolet radiation can be in the range of about 185 to about 220 nm (e.g., 193 nm) at energy pulses in the range of about 1500 to about 2000 and typically from about 500 to about 1000 mJ/cm$^2$. Optimally, pulsed radiation sources are preferred (rather than a continuous source) in order to provide a sufficient amount of photons in the irradiated area of the glass film in a very short span of time. An illustrative example is the pulsed laser radiation produced by an ArF excimer laser providing pulses of about 10 to about 20 (e.g., 12 to 14) nanoseconds half width at the threshold energy fluences indicated above. As will be understood, and noted above, other radiation sources can be used as for example, a $CO_2$ laser emitting radiation of a wavelength in the range of about 10.2 to about 10.6 $\mu$m at energy pulses in the range of about 250 in mJ/cm$^2$. An ArF excimer laser can be used which produces ultraviolet radiation (e.g., 193 nm or 248 nm or 380 nm) to rapidly and homogeneously etch the borosilicate glass without need for photolithography or special etching atmospheres. For most borosilicate glasses irradiated by ArF laser pulses 14 nanoseconds half width, it has been found that an energy fluence of 400 to 500 mJ/cm$^2$/pulse is sufficient to ablatively photodecompose the borosilicate glass. For glass-ceramics, the UV wavelength can be illustratively 193 nm.

## Claims

1.  A method for forming vias in a planar structure, comprising the steps of:
    A) superimposing over said planar structure a first metal mask (201) having a pattern of first apertures (203) therethrough, the planar structure comprising a dielectric layer (50, 98A) on a substrate (32, 80);

B) irradiating said structure with high energy photon radiation (204) through said first apertures (203) to ablate partial vias (205) through the top of and into said layer (50, 98A) in the areas opposite said first apertures (203), with the bottom of said partial vias (205) spaced from the bottom of said layer (50, 98A);

C) replacing said first mask (201) with a second mask (202) having a pattern of second apertures (206) extending therethrough, said pattern of second apertures (206) corresponding to said pattern of first apertures (203) of said first mask (201) with said pattern of second apertures (206) being substantially smaller than said first apertures (203); and aligning said second mask (202) so that said second apertures (206) are concentric with the partial vias (205), and irradiating the planar structure with the high energy photon radiation (204A) using

D) said second mask (202) to completely ablate through said dielectric layer (50, 98A) at areas opposite said second apertures (206) to form vias (207) having stepped-shoulder or counter-bored configuration.

2. The method of claim 1
characterized in that said vias (207) are ablated by laser drilling.

3. The method of claim 1
characterized in that said substrate (32) is comprised of a multi-layered ceramic having a pattern of a plurality of spaced and interconnected conductive planes (36) and including a patterned conductive plane (88) on the surface of said substrate (32) adjacent said layer (50), and portions of which are selectively exposed by said vias, the method further comprising forming a conductive second pattern (48, 104) on said structure including conductive interconnections (54) in said vias.

4. The method of claim 3
characterized in that said layer comprises glass.

5. The method of claim 3
characterized in that said layer is a borosilicate glass.

6. The method of claim 3
characterized by coating said structure with a second planar dielectric layer (98B); forming in accordance with claim 1 a second set of vias having a stepped-shouldered or counter-bored configuration in said second dielectric layer (98B) extending to selected portions of said conductive second pattern (104); and forming a conductive third pattern (146) on said second planar dielectric layer (98B) comprised of conductive interconnections in said second set of vias.

**Revendications**

1. Procédé pour former des trous de traversée dans une structure plane, caractérisé en ce qu'il comprend les étapes suivantes:

A) un premier masque métallique (201) percé d'un motif de premières ouvertures (203) est superposé à cette structure plane, laquelle comprend une couche diélectrique (50, 98A) sur un substrat (32, 80);

B) cette structure est irradiée avec un rayonnement de photons de haute énergie (204) à travers ces premières ouvertures (203) pour former par ablation des trous partiels de traversée (205) à travers la partie supérieure et dans cette couche (50, 98A) dans les surfaces faisant face à ces premières ouvertures (203), le fond de ces trous partiels de traversée (205) se trouvant à une certaine distance de la partie inférieure de cette couche (50, 98A);

C) ce premier masque (201) est remplacé par un second masque (202) percé d'un motif de secondes ouvertures (206), ce motif de secondes ouvertures (206) correspondant au motif des premières ouvertures (203) de ce premier masque (201), ce motif ayant des secondes ouvertures (206) sensiblement plus petites que ces premières ouvertures (203); ce second masque (202) est aligné de telle sorte que ces secondes ouvertures (206) sont concentriques avec les trous partiels de traversée (205), et la structure plane est irradiée avec le rayonnement de photons haute énergie (204A),

D) ce second masque (202) est utilisé pour enlever complètement par ablation cette couche diélectrique (50, 98A) au niveau des surfaces faisant face à ces secondes ouvertures (206) pour former des trous de traversée (207) ayant une configuration en gradins ou à contre-alésage.

2. Procédé suivant la revendication 1, caractérisé en ce que ces trous de traversée (207) sont creusés par perçage au laser.

3. Procédé suivant la revendication 1, caractérisé en ce que ce substrat (32) est composé d'une céramique multicouche ayant un motif formé par un grand nombre de plans conducteurs espacés et interconnectés (36) et comprenant un plan conducteur (88) pourvu d'un motif sur la surface de ce substrat (32) adjacente à cette couche (50), et dont des portions sont exposées de façon sélective par ces trous de traversée, le procédé comprenant de plus la formation d'un second motif conducteur (48, 104) sur cette structure comprenant des interconnexions conductrices (54) dans ces trous de traversée.

4. Procédé suivant la revendication 3, caractérisé en ce que cette couche comprend du verre.

5. Procédé suivant la revendication 3, caractérisé en ce que cette couche est un verre au borosilicate.

6. Procédé suivant la revendication 3, caractérisé en ce qu'on recouvre cette structure d'une seconde couche diélectrique plane (98B), on forme selon le procédé de la revendication 1 un second jeu de trous de traversée ayant une configuration en gradins ou à contre-alésage dans cette seconde couche diélectrique (98B) se prolongeant jusqu'à des parties sélectionnées de ce second motif conducteur (104), et l'on forme un troisième motif conducteur (146) sur cette seconde couche diélectrique plane (98B) composée d'interconnexions conductrices dans ce second jet de trous de traversée.

## Patentansprüche

1. Verfahren zur Herstellung von Durchgangslöchern in einer ebenen Struktur, mit den folgenden Schritten:

A) Überlagern der ebenen Struktur mit einer ersten Metallmaske (201) mit einem Muster von ersten hindurchgehenden Öffnungen (203), wobei die planare Struktur eine dielektrische Schicht (50, 98A) auf einem Substrat (32, 80) enthält;

B) Bestrahlen dieser Struktur mit hochenergetischer Photonenstrahlung (204) durch die ersten Öffnungen (203), um Teillöcher (205) durch die Oberseite der und in die Schicht (50, 98A) in den Bereichen gegenüber der ersten Öffnungen (203) zu schmelzen, wobei der Boden dieser Teillöcher (205) von dem Boden der Schicht (50, 98A) entfernt ist;

C) Ersetzen der ersten Maske (201) durch eine zweite Maske (202), die ein Muster von zweiten sich hindurcherstreckenden Öffnungen (206) aufweist, wobei das Muster der zweiten Öffnungen (206) dem Muster der ersten Öffnungen (203) der ersten Maske (201) entspricht, und mit zweiten Öffnungen (206), die im wesentlichen schmaler sind als die ersten Öffnungen (203), und Ausrichten der zweiten Maske (202), so daß die zweiten Öffnungen (206) konzentrisch mit den Teillöchern (205) übereinstimmen, und Bestrahlen der ebenen Struktur mit der hochenergetischen Photonstrahlung (204A) unter Verwendung

D) der zweiten Maske (202), um vollständig durch die dielektrische Schicht (50, 98A) in Bereichen gegenüber der zweiten Öffnungen (206) abzutragen, um Durchgangslöcher (207) zu formen, die eine gestuft-geschulterte oder gegengebohrte Ausgestaltung haben.

2. Verfahren nach Anspruch 1, dadurch gekennzeichnet, daß die Durchgangslöcher (207) durch Laser-Bohren gebildet werden.

3. Verfahren nach Anspruch 1, dadurch gekennzeichnet, daß das Substrat (32) eine Mehrschichtkeramik mit einer Vielzahl von mit Abstand voneinander angeordneten und miteinander verbundenen leitfähigen Ebenen (36) und einer leitfähigen Ebene (88) auf der Oberfläche des Substrats (32) angrenzend an die Schicht (50), und Abschnitte die selektiv durch die Durchgangslöcher freigelegt sind, aufweist, wobei das Verfahren weiterhin das Bilden eines leitfähigen zweiten Musters (48, 104) auf der Struktur einschließlich leitfähigen Zwischenverbindungen (54) in den Durchgangslöchern umfaßt.

4. Das Verfahren nach Anspruch 3, dadurch gekennzeichnet, daß die Schicht Glas aufweist.

5. Das Verfahren nach Anspruch 3, dadurch gekennzeichnet, daß die Schicht ein Borosilikatglas ist.

6. Verfahren nach Anspruch 3, gekennzeichnet durch Beschichten der Struktur mit einer zweiten ebenen dielektrischen Schicht (98B); Bilden in Übereinstimmung mit Anspruch 1 einen zweiten Satz von Durchgangslöchern mit einer gestuft-geschulterten oder gegengebohrten Ausgestaltung in der zweiten dielektrischen Schicht (98B), die sich zu ausgewählten Abschnitten des leitfähigen zweiten Musters (104) erstrecken; und Bilden eines leitfähigen dritten Musters (146) auf der zweiten ebenen dielektrischen Schicht (98B) mit leitfähigen Zwischenverbindungen in dem zweiten Satz von Durchgangslöchern.

FIG. 1

FIG. 2

FIG. 3

FIG. 5

11

## FIG. 4A

## FIG. 4B

## FIG. 4C

## FIG. 4D

FIG. 4E

FIG. 4F

FIG. 4G

FIG. 4H

13